# EUROPEAN PATENT SPECIFICATION

(11) **EP 3 822 646 B1**
(45) Date of publication and mention of the grant of the patent: **30.08.2023**
(21) Application number: 19209663.4
(22) Date of filing: 18.11.2019
(51) Int. Cl.: G01R 29/08

(54) **RF-HOOD FOR ANTENNA MEASUREMENTS AT LOW FREQUENCIES**
HF-HAUBE FÜR ANTENNENMESSUNGEN BEI NIEDRIGEN FREQUENZEN
CAPOT RF POUR LES MESURES D'ANTENNE À BASSES FRÉQUENCES

(43) Date of publication of application: 19.05.2021
(73) Proprietor: Airbus Defence and Space GmbH, 82024 Taufkirchen (DE)
(72) Inventor: Mössinger, Alexander, 82024 Taufkirchen (DE)
(74) Representative: Frenkel, Matthias Alexander

(56) References cited:
- WO-A1-03/075020
- DE-A1- 2 413 373
- US-A1- 2013 154 887

## Description

In the following, a RF-Hood for antenna measurements at low frequencies and a corresponding antenna measurement system is disclosed.

To measure characteristics and performance of an antenna at low frequencies, e.g. at frequencies around 435 MHz, several methods and devices are known. For a measurement of continuous wave signals, far-field gain measurement is the most common method. This method offers certain advantages. On the one hand, coupling between a probe antenna and the antenna under test, DUT, as such is minimized due to the far field arrangement. On the other hand, also the influence of absorber walls is reduced for the same reason. Further, the measurement arrangement may be calibrated with a reference antenna employing a standard-gain horn.

However, a far-field gain measurement requires a prepared anechoic chamber as well as reference equipment like the standard-gain horn and is, therefore, inflexible and inappropriate for non-stationary use. Further, the far-field gain measurement suffers from multiple-path effects such as ripples on measured RF characteristics and is sensitive to alignment errors. Additionally, timing-problems for pulsed measurements may occur since the far-field gain measurement requires naturally relative long cables. Due to the relative long cables, also an additional calibration of the cables may be required to compensate a temperature dependency of the cables employed.

To overcome these disadvantages cubical-shaped RF-Hoods comprising compacts dimensions have been designed for antenna measurements. These RF-Hoods are transportable and may be assembled and/or disassembled to an antenna/device under test, DUT. In consequence, these cubical-shaped RF-Hoods allow a compact measurement arrangement for an antenna, which allows measuring characteristic and performance of an antenna-feed, wherein the antenna feed may remain mounted on its current support structure or its current support environment. An anechoic chamber and long cables are rendered expendable by the employment of such a cubical RF-Hood for antenna measurements.

However, such cubical-shaped RF-Hoods must include absorber walls, which are arranged substantially perpendicular and, for low frequencies, relatively near to the antenna under test, DUT. In consequence, these absorber walls influence the measured DUT's RF-characteristics. In particular, the electromagnetic field distribution in front of a DUT applied to a cubical-shaped RF-Hood differs from the field distribution in front of the DUT under free space conditions. Further, probe antenna and DUT may couple with each other due to their near-field arrangement and, therefore, influence the measurement results.

The document WO 03/0750020 A1 discloses a device for the detection of electromagnetic pulses. The device comprises a line element, which runs through said device, and a housing surrounding the line element. The line element and the housing form a waveguide. A sensor element is arranged in the region between the housing and the line element.

Another waveguide arrangement is disclosed by the document DE 24 13 373 A1. The disclosed arrangement comprises a cone-shaped waveguide and an antenna positioned inside the cone-shaped waveguide.

Therefore, an enhanced RF-Hood optimized for characteristic and performance measurement of an antenna at low frequencies, e.g. frequencies around 435 MHz, is required.

This problem is solved by a device according to claim 1. Further embodiments of the invention are defined by the dependent claims.

An RF-Hood for antenna measurements at low frequencies comprises a waveguide and a first conductor coupled with the waveguide. The first conductor is formed by four electrically conductive walls, which form the lateral surfaces of a pyramidal frustum. A second conductor is formed by four electrically conductive walls, which form the lateral surfaces of a pyramidal frustum. The pyramidal frustum defined by the conductive walls of the first conductor may differ from the pyramidal frustum defined by the conductive walls of the second conductor.

The second conductor is configured to be coupled with an antenna under test, DUT, wherein "coupled with an antenna" means that the second conductor is coupled directly with an antenna and/or is coupled with a device, e.g. a ground plate, which is arranged at the antenna. In other words, coupling between the second conductor and the antenna may be realized as direct coupling or as indirect coupling employing additional means such as connecting devices, dielectrics, linkages, plates, antenna housings or sealing elements, wherein the antenna does not contact the second conductor as such.

The pyramidal frustum formed by the electrically conductive walls of the first conductor and/or the pyramidal frustum formed by the electrically conductive walls the second conductor may have a rectangular, particularly quadratic, base.

Further, the RF-Hood includes a third conductor coupled with the first conductor and coupled with the second conductor. The third conductor is formed by four electrically conductive walls, which define/form four, particularly lateral, surfaces of a cuboid. In other words, the four electrical conductive walls, which form the third conductor, can be arranged to form a tunnel or frame comprising a rectangular or quadratic cross-section profile.

The base of the pyramidal frustum formed by the electrically conductive walls of the first conductor may be congruent to the base of the pyramidal frustum formed by the electrically conductive walls of the second conductor. In other words, the base of the pyramidal frustum formed by the electrically conductive walls of the first conductor can be shaped identical to the base of the pyramidal frustum formed by the electrically conductive walls of the second conductor.

Further, the base of the pyramidal frustum formed by the first conductor and/or the second conductor can be congruent/identically shaped to a base of the cuboid formed by the four electrically conductive walls of the third conductor.

The first conductor and/or the second conductor and/or the third conductor can, at least partially, be covered with a microwave absorbing material. In particular, an inner surface of the RF-Hood formed by the first conductor and the second conductor and/or the third conductor is covered with a microwave absorbing material. In an example, microwave absorbing material may be arranged on at least a part of the surfaces of the first conductor and/or the second conductor and/or the third conductor.

The volume enclosed by the first conductor exceeds/is greater than the volume enclosed by the second conductor.

The second conductor forms an opening configured to be sealed by the antenna under test and/or by a device coupled with the antenna under test. This opening formed by the second conductor may be an opening turned-away from the base of the pyramidal frustum formed by the conductive walls of second conductor and/or turned-away form the waveguide coupled with the first conductor waveguide. The opening to be sealed by the antenna under test and/or by a device coupled with the antenna under test may be a plane parallel to the base of the pyramidal frustum formed by the conductive walls of the second conductor, wherein this plane is delineated by the four conductive walls.

The conductive walls of the first conductor and/or of the second conductor are trapezoid-shaped conductive plates. The conductive walls of the third conductor can be rectangular-shaped conductive plates.

The angles of the conductive walls of the first conductor and/or the second conductor may be chosen such that a remaining RF-backscattering, which is not avoided/prevented by the microwave absorbing material, in a direction back to the antenna under test is significantly reduced if e.g. compared with cuboid RF-Hoods. In particular, the angles of the conductive walls of the first conductor and/or the second conductor may be chosen such that corresponding free space impedance (e.g. 377 Ohm) is realized in front of the antenna under test and indicated by a reference face, RF. As a consequence, a field distribution in front of the antenna under test is realized that equals the field distribution in front of the antenna under test under free-space conditions (both for Rx and Tx operation).

The reference face, RF, can be positioned in parallel to the antenna under test and/or in parallel with the device coupled with the antenna under test, e.g. with an antenna ground plate, which seals the opening of the second conductor.

Further, the angles of the conductive walls of the first conductor and/or the second conductor may be chosen such that the RF-Hood realizes an impedance transformation such that the impedance in front of the antenna under test (e.g. within the reference face, RF) is transformed to the impedance of the waveguide coupled with the first conductor. This reduces backscattering from the waveguide and/or a probe antenna coupled with the waveguide back to the antenna under test.

In a variant, an angle α1 enclosed by a conductive wall of the first conductor and an (imaginary) straight line or plane extending perpendicularly from the base of a pyramidal frustum formed by the conductive walls of the first conductor may be 39° +/- 5°, particularly 39°. In other words, an angle α1 enclosed by a conductive wall of the first conductor and an (imaginary) straight line extending from the (imaginary/interpolated) spire of the pyramidal frustum formed by the conductive walls of the first conductor and perpendicularly meeting/passing/crossing the base of the pyramidal frustum formed by the conductive walls of the first conductor may be 39° +/- 5°, particularly 39°.

Further, an angle α2 enclosed by a conductive wall of the second conductor and an (imaginary) straight line or plane extending perpendicularly from the base of a pyramidal frustum formed by the conductive walls of the second conductor may be 54° +/- 5°, particularly 54°. In other words, an angle α2 enclosed by a conductive wall of the second conductor and an (imaginary) straight line extending from the (imaginary/interpolated) spire of the pyramidal frustum formed by the conductive walls of the second conductor and perpendicularly meeting/passing/crossing the base of the pyramidal frustum formed by the conductive walls of the second conductor may be 54° +/- 5°, particularly 54°.

Both above mentioned effects, the reference face, RF in front of and/or spaced apart from the antenna under test featuring free-space impedance and the impedance transformation from the impedance in front of the antenna under test to the impedance of the waveguide, are beneficial especially for low frequency measurements, e.g. around 435 MHz. On the one hand, a performance of known microwave absorbing materials is limited, particularly at relatively low frequencies. On the other hand, probe-antennas for low frequency measurements have to be comparatively large, which favors undesired backscattering or coupling. Since the double pyramidal frustum-shaped RF-Hood design reduces both negative effects, it is particularly advantageous for low frequency measurements.

An antenna measurement system comprises a RF-Hood according to preceding description and an antenna under test, DUT.

The antenna under test, DUT, and/or a device coupled with the antenna under test, e. g. connecting devices, dielectrics, linkages, plates, antenna housings or sealing elements, may seal an opening of the RF-Hood. The opening of the RF-Hood, which is sealed by the antenna under test and/or devices coupled with the antenna under test, can be an opening of the second conductor. Particularly, the opening to be sealed can be turned away from the first conductor and/or the turned away from the waveguide coupled to the first conductor.

The antenna measurement system can be configured for Rx and/or Tx measurements.

In an example, the antenna measurement system is optimized for antenna measurements at p band frequencies, particularly at/around 435 MHz.

In the following, the present disclosure will further be described with reference to exemplary implementations illustrated in the figures, in which:
- Figure 1: schematically illustrates an RF-Hood comprising a waveguide, a first conductor, a second conductor and a third conductor, wherein the shown RF-Hood is coupled with an antenna under test.
- Figure 2: shows a cross-sectional view of the arrangement shown in Fig. 1 along the imaginary cut axis X-X' shown in Fig. 1.
- Figure 3: shows the same cross-sectional view as Fig. 2, wherein, for the sake of clarity, some elements shown in Fig. 2 are hidden while other elements not explicitly shown in Fig. 2 are identified in Fig. 3.

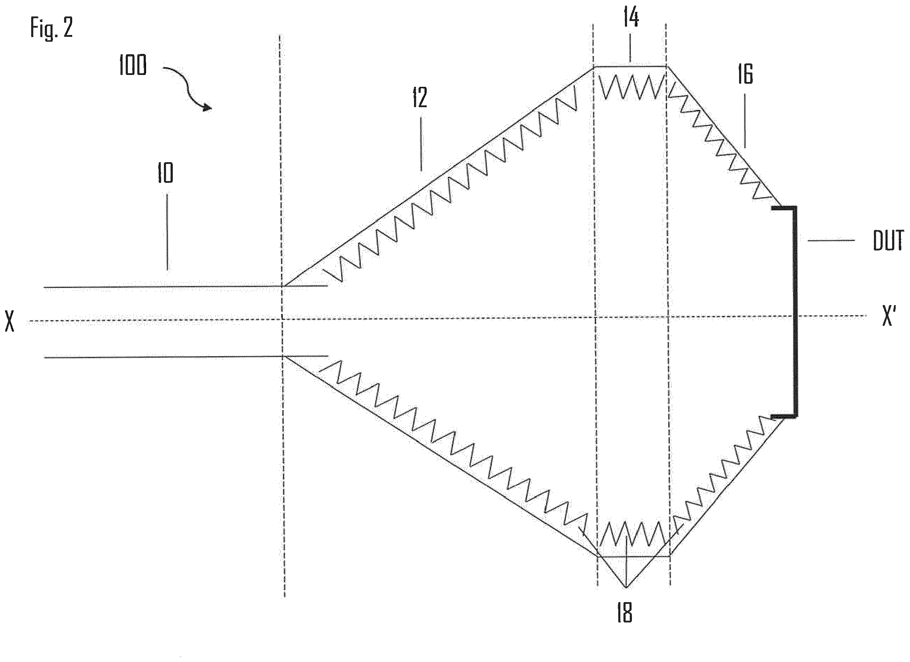

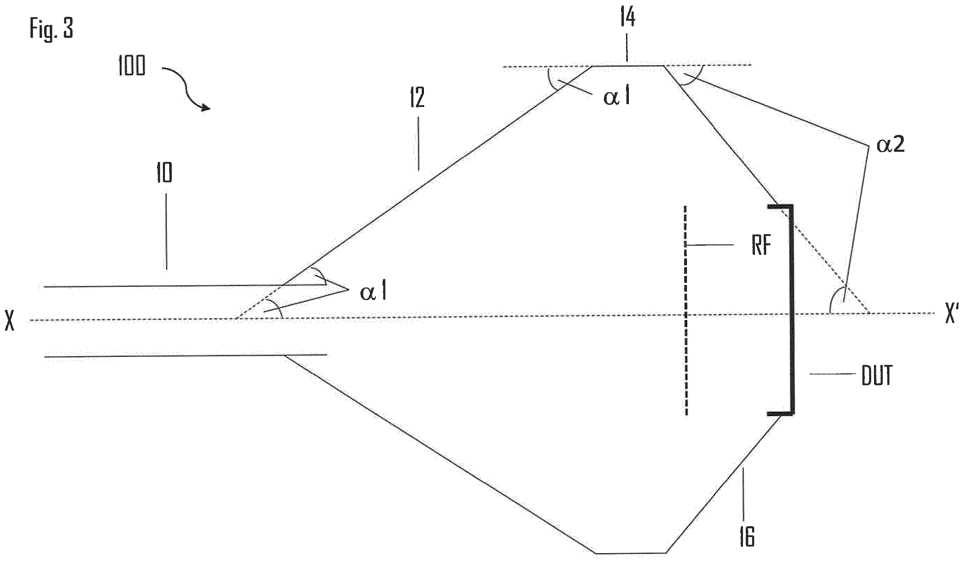

In the following description, for purposes of explanation and not limitation, specific details are set forth in order to provide a thorough understanding of the present disclosure. It will be apparent to one skilled in the art that the present disclosure may be practiced in other implementations that depart from the specific details. Devices and device elements shown in the Figures, which are identified by the same reference sings, correspond to each other. Further, it is explicitly reminded that the figures are merely schematically drawn and, therefore, merely serve to identify essential features. In consequence, the absence of a feature in the figures shown does not imply the mandatory absence of a feature in an implementation of the invention defined by claim 1. In particular with view to the Fig. 2 and 3, it is explicitly emphasized that all Figures show the same arrangement but each identify and hide different features of the arrangement shown.

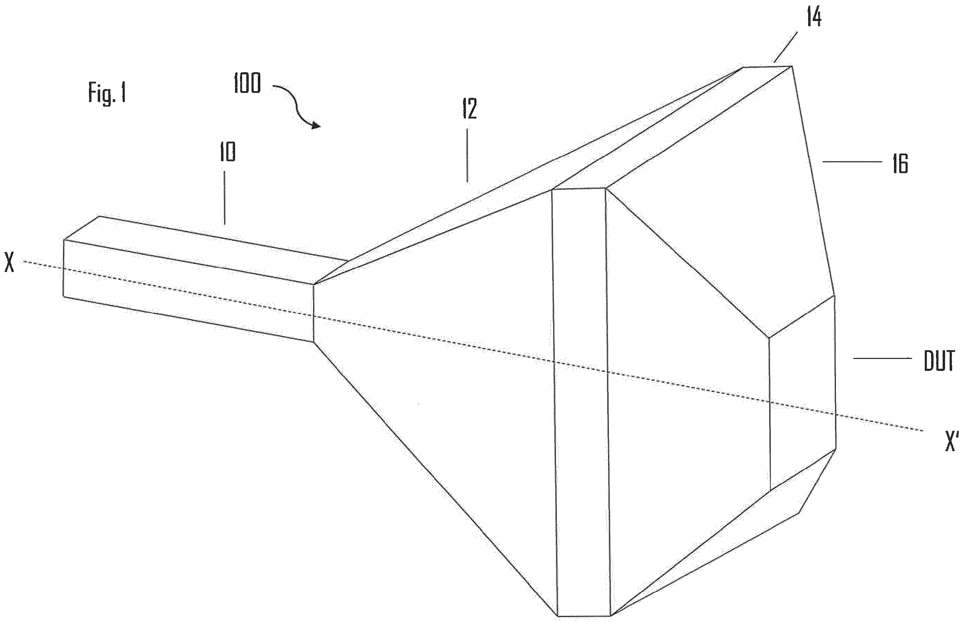

Fig. 1 shows an antenna measurement system 100 optimized for antenna measurements at low frequencies, in particular for frequencies around 435 MHz. The shown system 100 comprises a RF-Hood coupled with a device/antenna under test DUT.

The RF-Hood comprises a waveguide 10, a first conductor 12 and a second conductor 16.

The waveguide 10 is implemented by a hollow conductive metal pipe comprising a rectangular cross-sectional area. In other words, the waveguide 10 is implemented as a chimney-shaped cuboid hollow metal tube comprising a cuboid through-opening for guiding RF-waves, particularly RF-waves of a frequency around 435 MHz, there through.

The first conductor 12 is formed by four electrically conductive walls, which form the lateral surfaces of a pyramidal frustum. As shown, the first conductor 12 is coupled with the waveguide 10, wherein the waveguide 10 is arranged at an end of the first conductor 12 turned away from the quadratic base of the pyramidal frustum defined by the four conductive walls of the first conductor 12.

The second conductor 16 is also formed by four electrically conductive walls, which form the lateral surfaces of a pyramidal frustum. However, the pyramidal frustum defined by the conductive walls of the first conductor 12 differs from the pyramidal frustum defined by the conductive walls of the second conductor 16. Particularly, the first conductor 12 encloses a volume greater than the volume enclosed by the second conductor 16. The second conductor 16 is coupled with an antenna under test DUT. More precisely, the second conductor 16 is coupled with a ground plate of the antenna under test DUT.

Further, the shown RF-Hood includes a third conductor 14 coupled with the first conductor 12 and coupled with the second conductor 16, wherein the third conductor 16 is arranged between the first conductor14 and the second conductor 16. The shown third conductor 14 is formed by four electrically conductive walls, which define four lateral surfaces of a cuboid, wherein the base of the formed cuboid is congruent/identical shaped to the quadratic basis of the pyramidal frustums defined by the conductive walls of the first and the second conductor 12, 16.

In the shown examples, the conductors 12, 14, 16 are integrally formed from a single work piece. However, this is explicitly not required by all embodiments of the invention. For example, the conductors can be coupled or fixed to each other by mechanical means and/or coupled or fixed to each other permanently.

Together, the waveguide 10 and the conductors 12, 14, 16 form a double pyramidal frustum-shaped RF-Hood configured to couple with an antenna under test DUT.

In Fig. 2, which shows a cross-sectional view along the axis X-X' schematically indicated in Fig. 1, it is shown that a microwave absorbing material 18 is arranged at the conductors 12, 14, 16. More precisely, the microwave absorbing material 18 covers an inner surface of the RF-Hood formed by the first conductor 12, the second conductor 16 and the third conductor 14.

Further, Fig. 2 shows that the waveguide 10 is coupled to a first opening of the RF-Hood, while a second opening of the RF-Hood is sealed by an antenna arrangement. More precisely, the ground plate coupled to the antenna under test OUT seals the second opening of the RF-Hood.

Fig. 3, which shows the same arrangement as Fig. 2, shows a reference face RF of the antenna under test spaced apart to the antenna under test DUT as such. The reference face RF is positioned/arranged in parallel to the antenna arrangement and/or to the antenna ground plate, which seals the opening of the second conductor 16.

The angles of the conductive walls of the shown first conductor 12 and the shown second conductor 16 are chosen such that a remaining RF-backscattering, which is not prevented by the microwave absorbing material 18 (not shown in Fig. 3), in a direction back to the antenna under test OUT is significantly reduced if compared with a cuboid RF-Hood. Thus, corresponding free space impedance (e.g. 377 Ohm) is realized in front of the antenna under test at the shown reference face RF.

In the shown example, the angle α1 is enclosed by a conductive wall of the first conductor and an (imaginary) straight line extending perpendicularly from the base of a pyramidal frustum formed by the conductive walls of the first conductor 12 is 39°. Further, the angle α2 enclosed by a conductive wall of the second conductor and an (imaginary) straight line extending perpendicularly from the base of a pyramidal frustum formed by the conductive walls of the second conductor 16 is 54°. The (imaginary) straight lines extending form the bases of the pyramidal frustums 12, 16 are in parallel to an (imaginary) straight line perpendicularly extending from the bases of the pyramidal frustums to (imaginary/interpolated) spires of the pyramidal frustums 12, 16. In the show example, such a straight line is indicated by the axis X-X'.

The angles of the conductive walls of the first conductor 12 and/or the second conductor 16 may be chosen such that the RF-Hood provides an impedance transformation such that the impedance in front of the antenna under test OUT (e.g. within the reference face, RF) is transformed to the impedance of the waveguide 10 coupled with the first conductor 12. This reduces backscattering from the waveguide 10 and/or a probe antenna coupled with the waveguide back to the antenna under test DUT.

For the characterization of the antenna under test OUT a measurement device may be coupled to the waveguide 10 (e.g. to a network vector analyzer, a power meter, a spectrum analyzer, etc.).

In particular the following measurements can be performed:
- Measurement of input reflection of the antenna under test OUT under free-space conditions (Scattering parameters S11)
- Measurement of radiated power
- Measurement of signal distortions (Scattering parameters S21)
- Measurement of dual-polarized wave forms.

It is believed that the advantages of the technique presented herein will be fully understood from the foregoing description, and it will be apparent that various changes may be made in the form, constructions and arrangement of the exemplary aspects thereof without departing from the scope of the disclosure or without sacrificing all of its advantageous effects. Because the technique presented herein can be varied in many ways, it will be recognized that the disclosure should be limited only by the scope of the claims that follow.

## Claims

1. An RF-Hood for antenna measurements at low frequencies, comprising
a waveguide (10);
a first conductor (12) coupled with the waveguide (10) formed by four electrically conductive walls forming lateral surfaces of a pyramidal frustum;
a second conductor (16) formed by four electrically conductive walls forming lateral surfaces of a pyramidal frustum;
a third conductor (14) coupled with the first conductor (12) and coupled with the second conductor (16), wherein the third conductor is formed by four electrically conductive walls forming lateral surfaces of a cuboid; and wherein
the inner surfaces of the RF-Hood are covered with a microwave absorbing material, and wherein
the second conductor (16) forms an opening configured to be sealed by an antenna under test, DUT, and/or by a device coupled with the antenna under test, DUT,
**characterized in that**
the volume enclosed by the first conductor (12) exceeds the volume enclosed by the second conductor (16).

2. The RF-Hood according any proceeding claim, wherein
the pyramidal frustum formed by the electrically conductive walls of the first conductor (12) and/or the second conductor (16) has a rectangular, particularly quadratic, base.

3. The RF-Hood according any proceeding claim, wherein
the base of the pyramidal frustum formed by the electrically conductive walls of the first conductor (12) is congruent to the base of the pyramidal frustum formed by the electrically conductive walls of the second conductor (16).

4. The RF-Hood according any proceeding claim, wherein
the base of the pyramidal frustum formed by the first conductor (12) and/or the second conductor (16) is congruent to a base of the cuboid formed by the four electrically conductive walls of the third conductor.

5. The RF-Hood according any proceeding claim, wherein
a conductive wall of the first conductor (12) and a straight line extending perpendicularly from the base of the first conductor (12) enclose an angle α1, wherein the angle α1 is angle in the range of 34° to 43°, particularly 39°, and/or
a conductive wall of the second conductor (16) and a straight line extending perpendicularly from the base of the second conductor (16) enclose an angle α2, wherein the angle α2 is angle in the range of 49° to 58°, particularly 54°.

6. An Antenna measurement system (100) comprising
a RF-Hood according to any of the preceding claims; and
an antenna under test, DUT.

7. The antenna measurement system (100) according to the preceding claim, wherein
the antenna under test, DUT, and/or a device coupled with the antenna under test, DUT, seals an opening of the RF-Hood.

8. The antenna measurement system (100) according to the preceding claim, wherein
the opening of the RF-Hood, which is sealed by the antenna under test, DUT, and/or a device coupled with the antenna under test, DUT, is an opening of the second conductor (16) turned away from the first conductor (12) and/or the turned away from the waveguide (10) coupled to the first conductor.

9. The antenna measurement system (100) according to the preceding claim, further comprising
a reference face (RF) spaced apart from the antenna under test, DUT.

10. The antenna measurement system (100) according to the preceding claim,
wherein the reference face (RF) is in parallel to the antenna under test, DUT, and/or in parallel with the device coupled with the antenna under test, DUT, which seals the opening of the second conductor (16).

11. The antenna measurement system (100) according to any of the claims 6 to 10, wherein
the antenna measurement system (100) is configured for Rx and/or Tx measurements, and/or
the antenna measurement system (100) is configured for antenna measurements at frequencies in the p-band, particularly around 435 MHz.

12. The antenna measurement system (100) according to any of the claims 6 to 11, wherein
a free space impedance is realized in a reference face, RF, in front of the antenna under test, DUT.

13. The antenna measurement system (100) according to any of the claims 6 to 12, wherein
an impedance in front of the antenna under test, DUT, is transformed to an impedance of the waveguide (10) coupled with the first conductor (12).

## Patentansprüche

1. HF-Haube für Antennenmessungen bei niedrigen Frequenzen, umfassend
einen Wellenleiter (10);
einen ersten Leiter (12), der mit dem Wellenleiter (10) gekoppelt ist und der durch vier elektrisch leitfähige Wände gebildet wird, die Seitenflächen eines Pyramidenstumpfes bilden;
einen zweiten Leiter (16), der durch vier elektrisch leitfähige Wände gebildet wird, die Seitenflächen eines Pyramidenstumpfes bilden;
einen dritten Leiter (14), der mit dem ersten Leiter (12) gekoppelt ist und der mit dem zweiten Leiter (16) gekoppelt ist, wobei der dritte Leiter durch vier elektrisch leitfähige Wände gebildet wird, die Seitenflächen eines Quaders bilden; und wobei
die Innenflächen der HF-Haube mit einem mikrowellenabsorbierenden Material bedeckt sind, und wobei
der zweite Leiter (16) eine Öffnung ausbildet, die konfiguriert ist, um durch eine zu testende Antenne, DUT, und/oder durch eine mit der zu testenden Antenne, DUT, gekoppelte Vorrichtung verschlossen zu werden,
**dadurch gekennzeichnet, dass**
das durch den ersten Leiter (12) eingeschlossene Volumen das durch den zweiten Leiter (16) eingeschlossene Volumen übersteigt.

2. HF-Haube nach einem der vorhergehenden Ansprüche, wobei
der durch die elektrisch leitfähigen Wände des ersten Leiters (12) und/oder des zweiten Leiters (16) gebildete Pyramidenstumpf eine rechteckige, insbesondere quadratische, Basis aufweist.

3. HF-Haube nach einem der vorhergehenden Ansprüche, wobei
die Basis des durch die elektrisch leitfähigen Wände des ersten Leiters (12) gebildeten Pyramidenstumpfes kongruent zur Basis des durch die elektrisch leitfähigen Wände des zweiten Leiters (16) gebildeten Pyramidenstumpfes ist.

4. HF-Haube nach einem der vorhergehenden Ansprüche, wobei
die Basis des durch den ersten Leiter (12) und/oder durch den zweiten Leiter (16) gebildeten Pyramidenstumpfes kongruent zu einer Basis des durch die vier elektrisch leitfähigen Wände des dritten Leiters gebildeten Quaders ist.

5. HF-Haube nach einem der vorhergehenden Ansprüche, wobei
eine leitfähige Wand des ersten Leiters (12) und eine sich senkrecht von der Basis des ersten Leiters (12) erstreckende Gerade einen Winkel α1 einschließen, wobei der Winkel α1 ein Winkel im Bereich von 34° bis 43°, insbesondere 39°, ist, und/oder
eine leitfähige Wand des zweiten Leiters (16) und eine sich senkrecht von der Basis des zweiten Leiters (16) erstreckende Gerade einen Winkel α2 einschließen, wobei der Winkel α2 ein Winkel im Bereich von 49° bis 58°, insbesondere 54°, ist.

6. Antennenmesssystem (100), umfassend
eine HF-Haube nach einem der vorhergehenden Ansprüche; und
eine zu testende Antenne, DUT.

7. Antennenmesssystem (100) nach dem vorhergehenden Anspruch, wobei
die zu testende Antenne, DUT, und/oder eine mit der zu testenden Antenne, DUT, gekoppelte Vorrichtung eine Öffnung der HF-Haube verschließt.

8. Antennenmesssystem (100) nach dem vorhergehenden Anspruch, wobei
die Öffnung der HF-Haube, die durch die zu testende Antenne, DUT, und/oder durch eine mit der zu testenden Antenne, DUT, gekoppelte Vorrichtung verschlossen ist, eine Öffnung des zweiten Leiters (16) ist, die von dem ersten Leiter (12) abgewandt ist und/oder die von dem mit dem ersten Leiter gekoppelten Wellenleiter (10) abgewandt ist.

9. Antennenmesssystem (100) nach dem vorhergehenden Anspruch, weiter umfassend
eine Referenzfläche (RF), die von der zu testenden Antenne, DUT, beabstandet ist.

10. Antennenmesssystem (100) nach dem vorhergehenden Anspruch,
wobei die Referenzfläche (RF) parallel zu der zu testenden Antenne, DUT, und/oder parallel zu der mit der zu testenden Antenne, DUT, gekoppelten Vorrichtung ist, die die Öffnung des zweiten Leiters (16) verschließt.

11. Antennenmesssystem (100) nach einem der Ansprüche 6 bis 10, wobei
das Antennenmesssystem (100) für Rx- und/oder für Tx-Messungen konfiguriert ist, und/oder
das Antennenmesssystem (100) für Antennenmessungen bei Frequenzen im P-Band, insbesondere um 435 MHz herum, konfiguriert ist.

12. Antennenmesssystem (100) nach einem der Ansprüche 6 bis 11, wobei
ein Freiraumwellenwiderstand in einer Referenzfläche, RF, vor der zu testenden Antenne, DUT, realisiert ist.

13. Antennenmesssystem (100) nach einem der Ansprüche 6 bis 12, wobei
ein Wellenwiderstand vor der zu testenden Antenne, DUT, in einen Wellenwiderstand des mit dem ersten Leiter (12) gekoppelten Wellenleiters (10) transformiert wird.

## Revendications

1. Capot RF pour des mesures d'antenne à basses fréquences, comprenant
un guide d'ondes (10);
un premier conducteur (12) couplé au guide d'ondes (10) formé par quatre parois électroconductrices formant des surfaces latérales d'un tronc pyramidal;
un deuxième conducteur couplé au guide d'ondes (16) formé par quatre parois électroconductrices formant des surfaces latérales d'un tronc pyramidal;
un troisième conducteur (14) couplé au premier conducteur (12) et couplé au deuxième conducteur (16), dans lequel le troisième conducteur est formé par quatre parois électroconductrices formant les parois latérales d'un cuboïde; et dans lequel
les parois intérieures du capot RF sont recouvertes d'un matériau absorbant les microondes, et dans lequel
le deuxième conducteur (16) forme une ouverture conçue pour être rendue étanche par une antenne soumise à l'essai, DUT, et/ou par un dispositif couplé à l'antenne soumise à l'essai, DUT,
**caractérisé en ce que**
le volume renfermé par le premier conducteur (12) dépasse le volume enfermé par le deuxième conducteur (16).

2. Capot RF selon l'une quelconque revendication précédente, dans lequel
le tronc pyramidal formé par les parois électroconductrices du premier conducteur (12) et/ou du deuxième conducteur (16) ont une base rectangulaire, en particulier, quadratique.

3. Capot RF selon l'une quelconque revendication précédente, dans lequel
la base du tronc pyramidal formé par les parois électroconductrices du premier conducteur (12) coïncide avec la base du tronc pyramidal formé par les parois électroconductrices du deuxième conducteur (16).

4. Capot RF selon l'une quelconque revendication précédente, dans lequel
la base du tronc pyramidal formé par les parois électroconductrices du premier conducteur (16) et/ou du deuxième conducteur (16) coïncide avec une base du tronc pyramidal formé par les quatre parois électroconductrices du troisième conducteur.

5. Capot RF selon l'une quelconque revendication précédente, dans lequel
une paroi conductrice du premier conducteur (12) et une ligne droite partant perpendiculairement de la base du premier conducteur (12) renferment un angle α1, dans lequel l'angle α1 est un angle dans la plage de 34° à 43°, en particulier 39°, et/ou
une paroi conductrice du deuxième conducteur (16) et une ligne droite partant perpendiculairement de la base du deuxième conducteur (16) renferment un angle a2, dans lequel l'angle α2 est un angle dans la plage de 49° à 58°, en particulier 54°.

6. Système de mesure d'antenne (100) comprenant
un capot RF selon l'une quelconque des revendications précédentes; et
une antenne soumise à l'essai, DUT.

7. Système de mesure d'antenne (100) selon la revendication précédente, dans lequel l'antenne soumise à l'essai, DUT, et/ou un dispositif couplé à l'antenne soumise à l'essai, DUT, rend étanche une ouverture du capot RF.

8. Système de mesure d'antenne (100) selon la revendication précédente, dans lequel l'ouverture du capot RF, qui est rendue étanche par l'antenne soumise à l'essai, DUT, et/ou un dispositif couplé à l'antenne soumise à l'essai, DUT, est une ouverture du deuxième conducteur (16) tourné à l'opposé du premier conducteur (12) et/ou celui tourné à l'opposé du guide d'ondes (10) couplé au premier conducteur.

9. Système de mesure d'antenne (100) selon la revendication précédente, comprenant en outre une face de référence (RF) éloignée de l'antenne soumise à l'essai, DUT.

10. Système de mesure d'antenne (100) selon la revendication précédente,
dans lequel la face de référence (RF) est en parallèle avec l'antenne soumise à l'essai, DUT, et/ou en parallèle avec le dispositif couplé à l'antenne soumise à l'essai, DUT, qui rend étanche l'ouverture du deuxième conducteur (16).

11. Système de mesure d'antenne (100) selon l'une quelconque des revendications 6 à 10, dans lequel le système de mesure d'antenne (100) est conçu pour des mesures Rx et/ou Tx, et/ou
le système de mesure d'antenne (100) est conçu pour des mesures d'antenne à des fréquences dans la bande p, en particulier autour de 435 MHz.

12. Système de mesure d'antenne (100) selon l'une quelconque des revendications 6 à 11, dans lequel
une impédance d'espace libre est réalisée dans une face de référence, RF, devant l'antenne soumise à l'essai, DUT.

13. Système de mesure d'antenne (100) selon l'une quelconque des revendications 6 à 12, dans lequel
une impédance devant l'antenne soumise à l'essai, DUT, est transformée en une impédance du guide d'ondes (10) couplé au premier conducteur (12).
